# EUROPEAN PATENT APPLICATION

(11) **EP 2 328 186 A1**
(43) Date of publication of application: **01.06.2011**
(21) Application number: 10191782.1
(22) Date of filing: 18.11.2010
(51) Int. Cl.: H01L 31/048

(54) **Backplane for solar cell and solar cell comprising the same**

(30) Priority: 27.11.2009 CN 200910188449
(71) Applicant: Byd Company Limited, Shenzhen 518118 (CN)
(72) Inventor: Fang, Junxiang, 518118, Shenzhen (CN); Liu, Yunliang, 518118, Shenzhen (CN); Luo, Hui, 518118, Shenzhen (CN); Wang, Shengya, 518118, Shenzhen (CN); Jiang, Zhanfeng, 518118, Shenzhen (CN); He, Long, 518118, Shenzhen (CN)
(74) Representative: Gulde Hengelhaupt Ziebig & Schneider

(57) **Abstract**

A solar cell and a backplane for a solar cell, where the backplane comprises a metal substrate having first and second opposing major surfaces, and an insulating layer on one or both of the major surfaces of the metal substrate. The insulating layer comprises a resin selected from the group consisting of phenolic resins, epoxy resins, amino resins, and combinations thereof.

## Description

### CROSS-REFERENCE TO RELATED APPLICATION

The present application claims priority to and benefits of Chinese Patent Application No. 200910188449.4, filed with the State Intellectual Property Office of the People's Republic of China (SIPO) on November 27, 2009, the entire content of which is hereby incorporated by reference.

### FIELD

The present invention relates to a solar cell, more particularly to a backplane for a solar cell and a solar cell comprising this backplane.

### BACKGROUND

Solar energy is becoming more popular. The solar cell usually has a laminated structure, which comprises a transparent cover, a silicon substrate, a sealing film and a backplane. The backplane may enhance the mechanical strength and the sealing performance of the cell. Generally, it is required that the material of the backplane has the properties of high strength, high insulation, anti-aging, and high corrosion resistance.

### SUMMARY

In one aspect of the invention, a backplane for a solar cell is provided which comprises a metal substrate having first and second opposing major surfaces, and an insulating layer on at least one major surface of the metal substrate. The insulating layer comprises a resin selected from the group consisting of phenolic resins, epoxy resins, amino resins, and combinations thereof.

In another aspect of the invention, a backplane for a solar cell is provided which comprises a metal substrate having first and second opposing major surfaces; a coating layer on one or both of the first and second major surfaces of the metal substrate; and an insulating layer on the coating layer. The insulating layer comprises a resin selected from the group consisting of phenolic resins, epoxy resins, amino resins, and combinations thereof.

In yet another aspect of the invention, a solar cell is provided which comprises a backplane according to the present invention. Preferably the solar cell comprises a silicon substrate on the backplane.

### BRIEF DESCRIPTION OF THE DRAWINGS

Exemplary embodiments of the present invention will be described in detail based on the following figures.

Fig. 1 shows a laminated structure of the backplane according to one embodiment of the present invention.

Fig. 2 shows a laminated structure of the backplane according to another embodiment of the present invention.

### DETAILED DESCRIPTION OF THE DRAWINGS AND THE PREFERRED EMBODIMENTS

It will be appreciated by those of ordinary skill in the art that the disclosure may be embodied in other specific forms without departing from the spirit or essential character thereof. The presently disclosed embodiments are therefore considered in all respects to be illustrative and not restrictive.

According to the invention the backplane for a solar cell comprises a metal substrate and an insulating layer on the metal substrate. The metal substrate has first and second opposing major surfaces. The insulating layer can be coated on one major surface, or both major surfaces of the metal substrate. The insulating layer can be any suitable insulating material. Preferably, the insulating layer is a polymer material. More preferably, the insulating layer is made from a resin selected from the group consisting of phenolic resins, epoxy resins, amino resins, and combinations thereof.

In one embodiment of the invention, the insulating layer is formed by electrophoresis. During the electrophoresis process, the metal substrate is an electrode in an electrophoretic solution. The electrophoretic solution comprises a resin material. Under an external electric field, the particles of the resin material can migrate directionally and deposit onto the surface of the metal substrate to form an insulating layer.

The metal substrate can be any suitable metal material. In a preferred embodiment, the metal substrate is selected from the group consisting of stainless steel, iron, copper, aluminum, and combinations thereof. In one embodiment of the invention, the thickness of the metal substrate is from about 0.1 mm to about 1.5 mm.

The metal substrate can enhance the strength of the backplane, and has good heat dissipation and low transmission of water vapor. In one embodiment of the invention, the solar cell comprises a silicon substrate, a sealing film and a backplane. The insulating layer has a good adhesive force to the sealing film of the solar cell. It can enhance the insulating performance between the solar cell panel and the backplane.

In one embodiment of the invention, the phenolic resins are polymers formed by polycondensation of phenols and aldehydes. In another embodiment, the phenolic resins are selected from the group consisting of phenol-formaldehyde resins, phenylamine-modified phenolic resins, nitrile butadiene rubber-modified phenolic resins, and combinations thereof.

In one embodiment of the invention, the epoxy resins are macromolecules having two or more epoxy groups. In another embodiment, the epoxy resins are selected from the group consisting of bisphenol A epoxy resins, novolac epoxy resins, propanetriol epoxy resins, polyurethane-modified epoxy resins, and combinations thereof.

In one embodiment of the invention, the amino resins are formed by the polycondensation of amino compounds and formaldehyde. In another embodiment, the amino resins are selected from the group consisting of phenyl glycidyl ether amino resins, urea-formaldehyde resins, melamine formaldehyde resins, and combinations thereof.

In one embodiment of the invention, the thickness of the insulating layer is from about 10 µm to about 100 µm.

The metal substrate of the backplane comprises first and second major surfaces. In an embodiment of the invention, the first major surface is arranged to be the outside surface in a solar cell and the second major surface is arranged to be the inside surface in a solar cell. The outside surface is exposed to air. The inside surface is attached to the sealing film of the solar cell. In one embodiment of the invention, both of the two major surfaces are coated with an insulating layer. Preferably, the two insulating layers are made from different resin materials. In one embodiment, the insulating layer on the outside surface is made from resins having good watertightness and good weatherability. The insulating layer on the inside surface is made from resins having good insulating and adhesive performances.

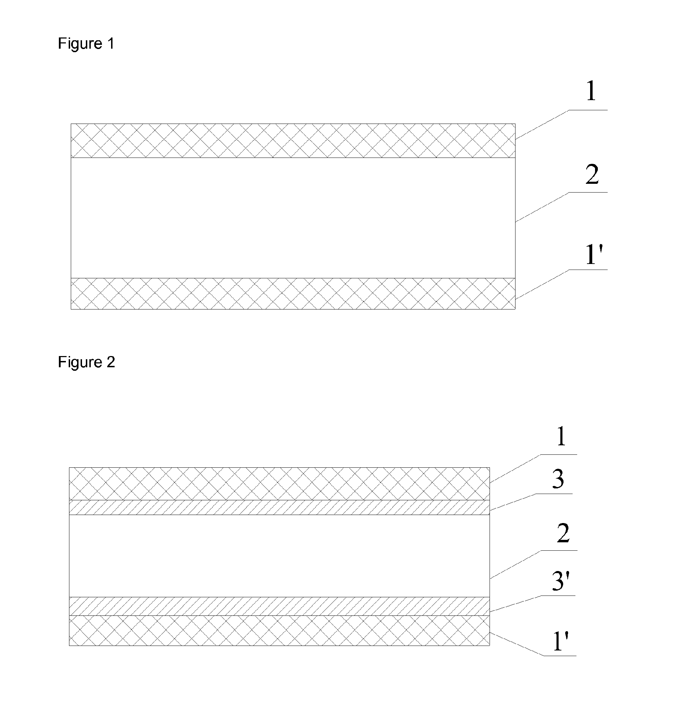

Referring to Figure 1, the backplane of one embodiment of the invention comprises a metal substrate 2, an insulating layer 1, and another insulating layer 1'.

According to a further embodiment of the present invention, the metal substrate comprises a coating layer on one or both of its surfaces. The coating layer can be any suitable material. Preferably, the coating layer comprises a material selected from zinc, nickel, and tin. More preferably, the coating layer is zinc. In one embodiment, the metal substrate has one coating layer on one of the major surfaces. In another embodiment, the metal substrate has two coating layers on both surfaces, respectively. The coating layer can be applied onto the surfaces of the metal substrate by any suitable method, such as e.g. plating.

Referring to Figure 2, the backplane of one embodiment of the invention comprises the metal substrate 2, the insulating layers 1 and 1', one coating layer 3 and the other coating layer 3'.

In one embodiment of the invention, the thickness of the coating layer is about 2 µm to about 50 µm.

In the harsh environment, some water vapor may get through the insulating layer to the metal substrate. The coating layer ensures the anticorrosion ability of the metal substrate.

In one embodiment, the insulating layer is formed by electrophoresis. This method provides an insulating layer with good compactness and hardness. Using metal substrates and electrophoresis processes can lower the costs.

The present invention also provides a solar cell comprising the backplane of the present disclosure. In one embodiment of the present invention the solar cell comprises the backplane of the present invention, and a silicon substrate on the backplane. Preferably, the solar cell comprises a transparent cover, the silicon substrate, a sealing film, and the backplane. The transparent cover is disposed on the silicon substrate. The sealing film is disposed between the silicon substrate and the backplane. More preferably, the solar cell comprises another sealing film disposed between the transparent cover and the silicon substrate.

In one embodiment of the invention, the transparent cover is glass. In a preferred embodiment of the invention the sealing film comprises ethylene vinyl acetate copolymer (EVA).

Hereinafter, the invention will be described in details with reference to the following embodiments.

### EMBODIMENT 1

A stainless steel substrate with two zinc coating layers on both major surfaces is used to form a backplane. The thickness of the stainless steel substrate is 0.5 mm. The thickness of the coating layer is 15 µm.

The first major surface of the stainless steel substrate is coated with a propanetriol epoxy resin layer by electrophoresis. The second major surface of the stainless steel substrate is coated with a polyurethane-modified epoxy resin layer by electrophoresis. The thickness of the propanetriol epoxy resin layer is 30 µm. The thickness of the polyurethane-modified epoxy resin layer is 35 µm.

The backplane is labeled as A1.

### EMBODIMENT 2

An aluminum substrate is used to form a backplane. The thickness of the aluminum substrate is 0.7 mm.

The first major surface of the aluminum substrate is coated with a polyurethane-modified epoxy resin layer by electrophoresis. The second major surface of the aluminum substrate is coated with a melamine formaldehyde resin layer by electrophoresis. The thickness of the polyurethane-modified epoxy resin layer is 40 µm. The thickness of the melamine formaldehyde resin layer is 30 µm.

The backplane is labeled as A2.

### EMBODIMENT 3

A stainless steel substrate with two zinc coating layers on both major surfaces is used to form a backplane. The thickness of the stainless steel substrate is 0.5 mm. The thickness of the plating coating is 15 µm.

Both major surfaces of the stainless steel substrate are coated with polyurethane-modified epoxy resin layers by electrophoresis. The thickness of the polyurethane-modified epoxy resin layer is 30 µm.

The backplane is labeled as A3.

### EMBODIMENT 4

A stainless steel substrate with two zinc coating layers on both major surfaces is used to form a backplane. The thickness of the stainless steel substrate is 0.3 mm. The thickness of the plating coating is 10 µm.

The first major surface of the stainless steel substrate is coated with a nitrile butadiene rubber-modified phenolic resin layer by electrophoresis. The second major surface of the stainless steel substrate is coated with a polyurethane-modified epoxy resin layer by electrophoresis. The thickness of the nitrile butadiene rubber-modified phenolic resin layer is 25 µm. The thickness of the polyurethane-modified epoxy resin layer is 35 µm.

The backplane is labeled as A4.

### EMBODIMENT 5

A stainless steel substrate with two zinc coating layers on both major surfaces is used to form a backplane. The thickness of the stainless steel substrate is 0.6 mm. The thickness of the plating coating is 8 µm.

The first major surface of the stainless steel substrate is coated with a nitrile butadiene rubber-modified phenolic resin layer by electrophoresis. The second major surface of the stainless steel substrate is coated with a polyurethane-modified epoxy resin layer by electrophoresis. The thickness of the nitrile butadiene rubber-modified phenolic resin layer is 20 µm. The thickness of the polyurethane-modified epoxy resin layer is 30 µm.

The backplane is labeled as A5.

### EMBODIMENT 6

A copper substrate with two zinc coating layers on both major surfaces is used to form a backplane. The thickness of the copper substrate is 0.5 mm. The thickness of the plating coating is 16 µm.

The first major surface of the copper substrate is coated with a polyurethane-modified epoxy resin layer by electrophoresis. The second major surface of the copper substrate is coated with a phenyl glycidyl ether amino resin layer by electrophoresis. The thickness of the polyurethane-modified epoxy resin layer is 42 µm. The thickness of the phenyl glycidyl ether amino resin layer is 20 µm.

The backplane is labeled as A6.

### CONTROL 1

A TPT material (tedlar-polyester-tedlar laminate) is used to form a backplane. The backplane is formed by binding and heat-pressing the three films of polyvinyl fluoride / polyethylene terephthalate / polyvinyl fluoride (PVF/PET/PVF) successively. The thickness of the PVF film is 25 µm. The thickness of the PET film is 0.3 mm.

The backplane is labeled as AC1.

### Testing

### (1) Insulating Performance.

Using the method of UL1703, the backplanes of A1- A6 and AC1 are tested at a high-voltage of 3000 V. The results are recorded in Table 1.

### (2) Transmission of Water Vapor.

The transmission of water vapor is tested using the method of ASTM F-1249, CaCl₂ moisture absorption. The testing parameters are: temperature of 38°C, humidity of 90%, and time of 24 hours. The results are recorded in Table 1.

### (3) Heat Dissipation.

The backplanes of A1- A6 and AC1 are used to prepare solar cell batteries with a size of 300x300 mm. The batteries are placed outdoor in the sun for about 2 hours. Then, the average temperature of each battery is tested by an infrared thermometer. The results are recorded in Table 1.

**Table 1**

| | Insulation at 3000 V | Transmission of Water Vapor (g/m³) | Average Temperature after Exposing to Sun (°C) |
|---|---|---|---|
| A1 | No Breakdown | 0.050 | 55.0 |
| A2 | No Breakdown | 0.050 | 55.6 |
| A3 | No Breakdown | 0.054 | 54.8 |
| A4 | No Breakdown | 0.051 | 54.9 |
| A5 | No Breakdown | 0.052 | 55.2 |
| AC1 | No Breakdown | 2.850 | 56.5 |

From Table 1, the backplanes of the embodiments of the present disclosure have better performances on transmittance of water vapor and heat dissipation. Furthermore, the cost of the backplanes of the embodiments in the present disclosure is lower than that of the TPT backplanes.

Many modifications and other embodiments of the present disclosure will come to mind to one skilled in the art to which the present disclosure pertains having the benefit of the teachings presented in the foregoing description. It will be apparent to those skilled in the art that variations and modifications of the present disclosure may be made without departing from the scope or spirit of the present disclosure. Therefore, it is to be understood that the invention is not to be limited to the specific embodiments disclosed and that modifications and other embodiments are intended to be included within the scope of the appended claims. Although specific terms are employed herein, they are used in a generic and descriptive sense only and not for purposes of limitation.

## Claims

1. A backplane for a solar cell comprising:
a metal substrate having first and second opposing major surfaces;
and
an insulating layer on one or both of the first and second major surfaces of the metal substrate;
wherein the insulating layer comprises a resin selected from the group consisting of phenolic resins, epoxy resins, amino resins, and combinations thereof.

2. The backplane of claim 1 comprising an insulating layer on each of the first and second major surfaces, wherein the two insulating layers comprise different resins.

3. The backplane of claim 1 or 2, wherein the phenolic resin is selected from the group consisting of phenol-formaldehyde resins, phenylamine-modified phenolic resins, nitrile butadiene rubber-modified phenolic resins, and combinations thereof.

4. The backplane of one of the preceding claims, wherein the epoxy resin is selected from the group consisting of bisphenol A epoxy resins, novolac epoxy resins, propanetriol epoxy resins, polyurethane-modified epoxy resins, and combinations thereof.

5. The backplane of one of the preceding claims, wherein the amino resin is selected from the group consisting of phenyl glycidyl ether amino resins, urea formaldehyde resins, melamine formaldehyde resins, and combinations thereof.

6. The backplane of one of the preceding claims, wherein the thickness of the insulating layer is from about 10 µm to about 100 µm.

7. The backplane of one of the preceding claims, wherein the insulating layer is formed by electrophoresis.

8. The backplane of one of the preceding claims, wherein the metal substrate is selected from the group consisting of stainless steel, iron, copper, and aluminum.

9. The backplane of one of the preceding claims, wherein the thickness of the metal substrate is about 0.1 mm to about 1.5 mm.

10. The backplane of one of the preceding claims, wherein the metal substrate further comprises a coating layer on one or both of the first and second major surfaces, and wherein the insulating layer is on the coating layer.

11. The backplane of claim 10, wherein the coating layer is selected from the group consisting of zinc, nickel, and tin.

12. The backplane of claim 10 or 11, wherein the thickness of the coating layer is from about 2 µm to about 50 µm.

13. A solar cell comprising the backplane according to anyone of claims 1 to 12.

14. The solar cell of claim 13 comprising a silicon substrate on the backplane, a transparent cover on the silicon substrate and a sealing film disposed between the silicon substrate and the backplane.

15. The solar cell of claim 14, wherein the sealing film comprises ethylene vinyl acetate copolymer.

## Amended claims

### Amended claims in accordance with Rule 137(2) EPC.

**1.** A method of producing a backplane for a solar cell comprising:
a metal substrate having first and second opposing major surfaces; and
an insulating layer on one or both of the first and second major surfaces of the metal substrate;
wherein the insulating layer comprises a resin selected from the group consisting of phenolic resins, epoxy resins, amino resins, and combinations thereof,
**characterized in that**
the insulating layer is formed by electrophoresis.

**2.** The method of claim 1 wherein an insulating layer is formed on each of the first and second major surfaces, wherein the two insulating layers comprise different resins.

**3.** The method of claim 1 or 2, wherein the phenolic resin is selected from the group consisting of phenol-formaldehyde resins, phenylamine-modified phenolic resins, nitrile butadiene rubber-modified phenolic resins, and combinations thereof.

**4.** The method of one of the preceding claims, wherein the epoxy resin is selected from the group consisting of bisphenol A epoxy resins, novolac epoxy resins, propanetriol epoxy resins, polyurethane-modified epoxy resins, and combinations thereof.

**5.** The method of one of the preceding claims, wherein the amino resin is selected from the group consisting of phenyl glycidyl ether amino resins, urea formaldehyde resins, melamine formaldehyde resins, and combinations thereof.

**6.** The method of one of the preceding claims, wherein the thickness of the insulating layer is from about 10 µm to about 100 µm.

**7.** The method of one of the preceding claims, wherein the metal substrate is selected from the group consisting of stainless steel, iron, copper, and aluminum.

**8.** The method of one of the preceding claims, wherein the thickness of the metal substrate is about 0.1 mm to about 1.5 mm.

**9.** The method of one of the preceding claims, wherein a coating layer is formed on one or both of the first and second major surfaces of the metal substrate, and wherein the insulating layer is formed on the coating layer.

**10.** The method of claim 9, wherein the coating layer is selected from the group consisting of zinc, nickel, and tin.

**11.** The method of claim 9 or 10, wherein the thickness of the coating layer is from about 2 µm to about 50 µm.
